Europäisches Patentamt

European Patent Office

Office européen des brevets

(19)

(11) **EP 0 750 311 B1**

(12) **FASCICULE DE BREVET EUROPEEN**

(45) Date de publication et mention
de la délivrance du brevet:
**29.03.2000 Bulletin 2000/13**

(51) Int Cl.7: **G11C 7/06**, G11C 11/409

(21) Numéro de dépôt: **96401319.7**

(22) Date de dépôt: **18.06.1996**

(54) **Amplificateur de ligne pour mémoire statique RAM**

Leitungsverstärker für statische RAM-Speicher

Static RAM line amplifier

(84) Etats contractants désignés:
**DE GB IT NL**

(30) Priorité: **19.06.1995 FR 9507298**

(43) Date de publication de la demande:
**27.12.1996 Bulletin 1996/52**

(73) Titulaire: **MHS**
**44087 Nantes Cédex 03 (FR)**

(72) Inventeur: **Piquet, Philippe Franck**
**78180 Montigny-le-Bretonneux (FR)**

(74) Mandataire: **Fréchède, Michel**
**Cabinet Plasseraud**
**84, rue d'Amsterdam**
**F-75440 Paris Cédex 09 (FR)**

(56) Documents cités:
**EP-A- 0 434 090          EP-A- 0 626 693**

**Description**

L'invention concerne un amplificateur de ligne pour mémoire statique RAM, mémoire à accès aléatoire.

En raison de l'évolution rapide des technologies d'intégration de circuits intégrés actuellement mises en oeuvre, les mémoires RAM statiques présentent une densité d'intégration de plus en plus grande. En conséquence, toutes les parties ou zones de ces mémoires doivent être optimisées afin de permettre un accès aux données mémorisées aussi rapide que possible.

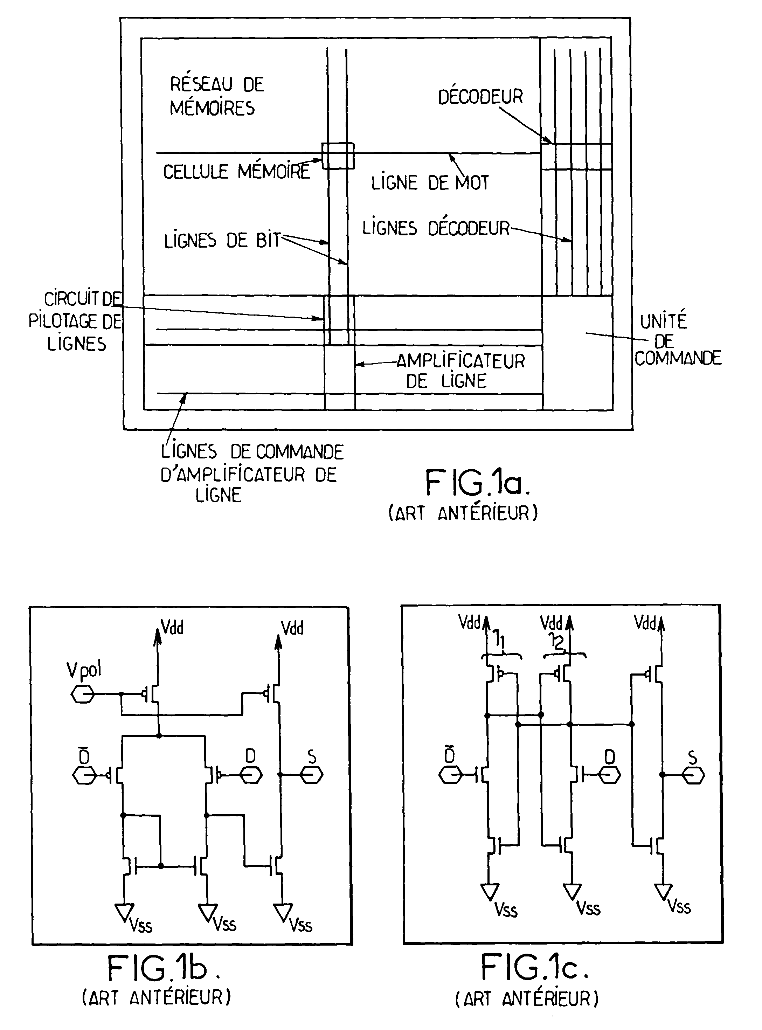

Ainsi qu'on l'a représenté schématiquement en figure 1a, une mémoire de ce type est constituée par un ensemble de modules analogiques et numériques, c'est-à-dire cellules de mémorisation bit, circuits de pilotage de lignes de bit, amplificateurs de ligne et décodeurs. De manière habituelle, des portes de type classique sont utilisées pour rendre les décodeurs plus rapides, la partie la plus délicate étant constituée par les amplificateurs de ligne. Les circuits de pilotage de lignes permettent d'alimenter le réseau de cellules mémoires sous forme numérique.

En ce qui concerne de manière plus spécifique l'organisation de telles mémoires, ainsi que représenté sur la figure 1a précitée, on rappelle qu'une telle mémoire est en fait constituée par un grand réseau contenant un certain nombre de cellules mémoires (parfois plus d'un million), formant un réseau de mémoires et de cellules auxiliaires fréquemment reproduites. Les cellules principales déterminant le dimensionnement et l'implantation d'une mémoire sont les cellules mémoires, les décodeurs, les circuits de pilotage de ligne, les amplificateurs de ligne et l'unité de commande. Certaines cellules comprennent quelques transistors, d'autres sont des macro-cellules qui doivent être divisées en cellules élémentaires.

Le plus souvent, il est opportun de placer chaque amplificateur de ligne à proximité de l'accès extérieur afin d'y introduire de petits circuits tampons et de réduire ainsi la charge du dispositif.

En ce qui concerne les amplificateurs de ligne, deux types différents sont actuellement utilisés : l'amplificateur de ligne à miroir de courant et l'amplificateur à réaction positive, tels que représentés en figure 1b et 1c respectivement.

Chacun des deux types d'amplificateur précités présente des avantages et des inconvénients.

L'amplificateur de ligne à miroir de courant est très stable mais lent, deux ou trois étages devant être connectés en cascade afin d'obtenir un grand gain. Dans le cas où il apparaît de petites impulsions de tension parasite sur les entrées, la sortie recouvre toujours son état initial, après un certain temps.

L'amplificateur de ligne à réaction positive comprend une première et une deuxième branche $1_1$, $1_2$ entre lesquelles la réaction positive est réalisée, et un étage de sortie. Il présente un grand gain, mais, en conséquence, n'est pas suffisamment stable. En conséquence, un seul étage est suffisant. Lorsque la différence de tension entre les entrées D, $\bar{D}$ est suffisamment importante, la sortie commute.

Si la bascule bistable, formée par la réaction positive, commute vers son état complémenté de manière intempestive, en raison du bruit par exemple, l'état initial d'origine n'est jamais recouvré dans un temps suffisamment court.

Enfin, il faut rappeler que les amplificateurs de ligne à miroir de courant et à réaction positive sont souvent commandés par des signaux de commande afin de réduire la dissipation d'énergie ou le niveau de bruit.

La présente invention a pour objet de remédier aux inconvénients précités, par la mise en oeuvre d'un amplificateur de ligne pour mémoire statique RAM, du type à réaction positive, présentant toutefois un temps de commutation très bref.

Un autre objet de la présente invention est la mise en oeuvre d'un amplificateur de ligne pour mémoire statique RAM, du type à réaction positive, dans lequel la consommation électrique statique est réduite.

Un autre objet de la présente invention est la mise en oeuvre d'un amplificateur de ligne pour mémoire statique RAM, du type à réaction positive, dans lequel la consommation électrique dynamique, lors des commutations, est également réduite en raison de commutations réalisées en deux phases.

Un autre objet de la présente invention est la mise en oeuvre d'un amplificateur de ligne pour mémoire statique RAM, du type à réaction positive, dans lequel la détection des données établies est facilitée grâce à la mise en oeuvre des signaux logiques correspondants et de leur complément logique.

Un autre objet de la présente invention est la mise en oeuvre d'un amplificateur de ligne pour mémoire statique RAM, du type à réaction positive, dans lequel un verrouillage du signal de sortie peut facilement être réalisé.

L'amplificateur de ligne pour mémoire statique RAM, objet de la présente invention, comprend un étage différentiel à réaction positive entre une première et deuxième branche connectées entre une tension d'alimentation et une tension de référence, chaque branche recevant au moins un signal bit respectivement le signal bit complémenté et un étage de sortie délivrant un signal de lecture bit.

Il est remarquable en ce que la première branche comporte au moins un premier transistor PMOS et un deuxième transistor NMOS connectés en série entre la tension d'alimentation et la tension de référence. L'électrode de grille du premier transistor PMOS reçoit le signal bit et est reliée à l'électrode de grille du premier transistor NMOS par l'intermédiaire d'une diode permettant de limiter la valeur basse de la tension appliquée sur l'électrode de grille du premier transistor PMOS à une valeur positive déterminée, l'électrode de grille du deuxième transistor NMOS recevant un signal de commande en lecture.

La deuxième branche comporte au moins un deuxième transistor PMOS et un troisième transistor NMOS connectés en série entre la tension d'alimentation et le point commun drain-source du premier et du deuxième transistor NMOS de la première branche. L'électrode de grille du deuxième transistor PMOS reçoit le signal bit complémenté et est reliée à l'électrode de grille du troisième transistor par l'intermédiaire d'une diode permettant de limiter la valeur basse de la tension appliquée sur l'électrode de grille du deuxième transistor PMOS à la valeur de seuil positive déterminée. Le deuxième transistor NMOS est commun à la première et à la deuxième branche et permet d'amplifier la différence préliminaire entre les niveaux de tension engendrés par une transition du signal bit et du signal bit complémenté. La première et la deuxième branche comportent en outre un transistor NMOS de précharge connecté entre la tension d'alimentation et le point commun drain-source entre le premier, le deuxième et le troisième transistor NMOS de la première et de la deuxième branche, l'électrode de grille du transistor de précharge recevant un signal de commande de précharge.

La réaction positive est formée par une première liaison directe entre le point commun drain-source du premier transistor PMOS et du premier transistor NMOS de la première branche et l'électrode de grille du troisième transistor NMOS de la deuxième branche, par une deuxième liaison directe entre le point commun drain-source du deuxième transistor PMOS et du troisième transistor NMOS de la deuxième branche et l'électrode de grille du premier transistor NMOS de la première branche et par un transistor de commutation de type PMOS reliant la première et la deuxième liaison directe et dont l'électrode de grille est commandée par le signal de précharge complémenté.

L'amplificateur de ligne pour mémoire statique RAM, objet de la présente invention, trouve application à la réalisation de mémoires statiques RAM sous forme de circuit intégré en technologie CMOS.

Il sera mieux compris à la lecture de la description et à l'observation des dessins ci-après dans lesquels, outre les figures 1a, 1b et 1c relatives à des dispositifs connus de l'art antérieur :

- la figure 2a représente un schéma illustratif de la structure de l'amplificateur de ligne pour mémoire statique RAM, objet de la présente invention ;
- la figure 2b représente, de manière qualitative, un chronogramme des principaux signaux mis en évidence en différents points de test de la figure 2a ;
- les figures 3a et 3b représentent un chronogramme de signaux en des points de test remarquables de la figure 2a.

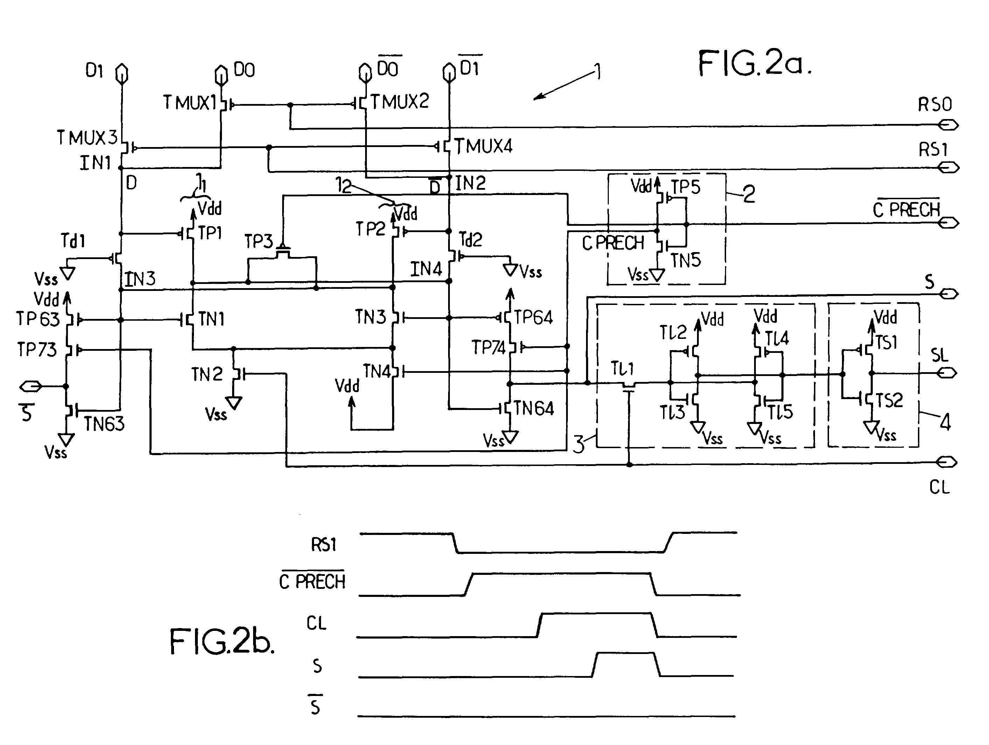

Une description plus détaillée d'un amplificateur de ligne pour mémoire statique RAM, objet de la présente invention, sera maintenant donnée en liaison avec les figures 2a et 2b.

Ainsi qu'on pourra le constater à l'observation de la figure 2a précitée, on indique que l'amplificateur de ligne pour mémoire statique RAM, selon l'invention, comprend un étage différentiel 1 à réaction positive entre une première et une deuxième branche, la première et la deuxième branche portant les références $1_1$ et $1_2$ respectivement sur la figure précitée. La première et la deuxième branche sont connectées entre une tension d'alimentation, notée Vdd, et une tension de référence Vss, cette tension de référence étant constituée par la tension de masse de l'amplificateur.

D'une manière générale, on indique que chaque branche, première et deuxième branche $1_1$, $1_2$, reçoit au moins un signal bit, noté D, et le signal bit complémenté, noté $\bar{D}$, le signal bit et le signal bit complémenté étant normalement délivrés par une cellule mémoire déterminée du réseau de mémoire sur commande classique au moyen des lignes de mots et lignes de bits tel que représenté en figure 1a.

De manière plus spécifique, ainsi qu'il apparaît sur la figure 2a, on indique que, de manière avantageuse, le signal bit D respectivement le signal bit complémenté $\bar{D}$ peuvent être constitués par l'un parmi une pluralité de signaux bit respectivement de signaux bit complémentés, notés sur la même figure 2a $D_1, D_0$, respectivement $\bar{D}_0, \bar{D}_1$, le nombre de signaux bit susceptible d'être appliqué à la première $1_1$ respectivement à la deuxième $1_2$ branche n'étant bien entendu pas limité à deux.

Selon un aspect particulier de l'amplificateur de ligne pour mémoire statique RAM, objet de la présente invention, tel que représenté en figure 2a, on indique que le signal bit D et le signal complémenté $\bar{D}$ sont alors appliqués à la première branche $1_1$ respectivement à la deuxième branche $1_2$, à partir de l'ensemble des signaux bit $D_1, D_0$, respectivement des signaux bit complémentés $\bar{D}_0, \bar{D}_1$ par l'intermédiaire de transistors de multiplexage notés $T_{mux1}$, $T_{mux2}$ et $T_{mux3}$, $T_{mux4}$. On indique que les transistors de multiplexage précités sont connectés en commutation afin d'assurer la transmission de l'un ou l'autre des signaux bit précités sur un noeud interne, noté $IN_1$ pour la première branche respectivement $IN_2$ pour la deuxième branche. La commande des transistors de multiplexage précités est réalisée par l'intermédiaire de signaux de commande appliqués à l'électrode de grille des transistors de multiplexage $T_{mux1}$, $T_{mux2}$ pour les signaux bit $D_0$ et bit complémenté $\bar{D}_0$, ce signal de commande étant noté $RS_0$, et par un signal correspondant complémenté $RS_1$ appliqué à l'électrode de grille des transistors de multiplexage $T_{mux3}$, $T_{mux4}$ pour les signaux bit $D_1$ et bit complémenté $\bar{D}_1$. Par l'application des signaux de commande $RS_0$ et $RS_1$, le signal bit D et le signal bit complémenté $\bar{D}$ est appliqué aux noeuds internes $IN_1$ respectivement $IN_2$ et ainsi le signal bit $D_0$ ou $D_1$ respectivement le signal bit complémenté $\bar{D}_0$ respectivement $\bar{D}_1$.

En outre, de manière classique, l'amplificateur de ligne pour mémoire statique RAM, objet de l'invention, comprend, ainsi que représenté sur la figure 2a précitée, un étage de sortie, portant la référence 4, lequel délivre un signal de lecture bit, noté SL, ainsi qu'il sera décrit ultérieurement dans la description.

Selon un aspect particulièrement avantageux de l'amplificateur de ligne objet de la présente invention, on indique que la première branche $1_1$ comporte au moins un premier transistor PMOS, noté $TP_1$, un premier transistor NMOS, noté $TN_1$, et un deuxième transistor NMOS, noté $TN_2$, connectés en série entre la tension d'alimentation Vdd et la tension de référence Vss. L'électrode de grille du premier transistor PMOS $TP_1$ reçoit le signal bit D délivré par multiplexage dans les conditions précédemment mentionnées dans la description. L'électrode de grille précitée est reliée à l'électrode de grille du premier transistor NMOS $TN_1$ par l'intermédiaire d'une diode portant la référence $Td_1$. Cette diode permet de limiter la valeur basse de la tension appliquée sur l'électrode de grille du premier transistor PMOS $TP_1$ lors de la commutation du signal bit D, cette tension appliquée étant limitée de ce fait à une valeur positive déterminée, laquelle est liée à la tension de seuil de la diode $Td_1$ précédemment citée. L'électrode de grille du deuxième transistor NMOS $TN_2$ reçoit un signal de commande en lecture, noté CL, lequel est délivré par l'unité de commande de manière classique.

En outre, ainsi qu'on l'a également représenté en figure 2a, la deuxième branche $1_2$ comporte au moins un deuxième transistor PMOS, noté $TP_2$, et un troisième transistor NMOS, noté $TN_3$, connectés en série entre la tension d'alimentation Vdd et le point commun drain-source du premier et du deuxième transistor NMOS, $TN_1$, $TN_2$ de la première branche $1_1$.

Sur la représentation de l'amplificateur de ligne pour mémoire statique RAM, objet de la présente invention, de la figure 2a, on indique que le point représenté au niveau d'une des électrodes des transistors PMOS, respectivement NMOS, désigne l'électrode de ce transistor de drain ou de source portée au potentiel le plus haut en ce qui concerne les transistors PMOS respectivement au potentiel le plus bas en ce qui concerne les transistors NMOS.

En outre, l'électrode de grille du deuxième transistor PMOS $TP_2$ reçoit le signal bit complémenté $\overline{D}$, cette électrode étant reliée à l'électrode de grille du troisième transistor NMOS $TN_3$ de manière symétrique à l'électrode de grille du premier transistor PMOS $TP_1$ de la première branche $1_1$, par l'intermédiaire d'une diode portant la référence $Td_2$. La diode $Td_2$ permet, de manière analogue, de limiter la valeur basse de la tension appliquée sur l'électrode de grille du deuxième transistor PMOS $TP_2$ à la valeur de seuil positive déterminée, précédemment mentionnée relativement à la diode portant la référence $Td_1$.

Bien entendu, dans un mode de réalisation spécifique, les diodes $Td_1$ et $Td_2$ peuvent être réalisées par des composants appariés de façon que les valeurs de seuil introduites soient sensiblement égales.

Selon un autre aspect particulièrement avantageux de l'amplificateur de ligne pour mémoire statique RAM, objet de la présente invention, on remarquera que le deuxième transistor NMOS $TN_2$ est commun à la première et à la deuxième branche $1_1$, $1_2$. Ce deuxième transistor NMOS $TN_2$ permet d'amplifier la différence préliminaire entre les niveaux de tension engendrés par une transition du signal bit D et du signal bit complémenté $\overline{D}$.

Enfin, les première et deuxième branches $1_1$ et $1_2$ comportent en outre en commun un transistor NMOS de précharge, noté $TN_4$. Ce transistor est connecté entre la tension d'alimentation Vdd et le point commun drain-source entre le premier, le deuxième et le troisième transistor NMOS $TN_1$, $TN_2$, $TN_3$ de la première et de la deuxième branche, $1_1$, $1_2$. L'électrode de grille du transistor de précharge $TN_4$ reçoit un signal de commande de précharge, noté CPrech, lequel est également engendré à partir de l'unité de commande.

Enfin, la réaction positive entre la première et la deuxième branche $1_1$ et $1_2$ est, ainsi que représenté en figure 2a, avantageusement formée par une première liaison directe entre le point commun drain-source du premier transistor PMOS $TP_1$ et du premier transistor NMOS $TN_1$ de la première branche et l'électrode de grille du troisième transistor NMOS $TN_3$ de la deuxième branche $1_2$. Une deuxième liaison directe entre le point commun drain-source du deuxième transistor PMOS $TP_2$ et du troisième transistor NMOS $TN_3$ de la deuxième branche et l'électrode de grille du premier transistor NMOS $TN_1$ de la première branche est en outre prévue pour réaliser la réaction positive précitée.

Enfin, et selon un aspect particulièrement avantageux de l'amplificateur de ligne pour mémoire statique RAM selon l'invention, un transistor de commutation de type PMOS, portant la référence $TP_3$, est prévu, ce transistor de commutation reliant la première et la deuxième liaison directe précitées. L'électrode de grille du transistor de commutation $TP_3$ est commandée par le signal de commande de précharge complémenté, noté $\overline{CPrech}$.

D'une manière générale, on indique que le signal de précharge complémenté noté $\overline{CPrech}$ est délivré par l'unité de commande, tel que représenté en figure 1a, et que, d'une manière avantageuse, l'amplificateur selon l'invention telle que représentée en figure 2a peut être muni d'un inverseur, portant la référence 2, recevant le signal de commande de précharge complémenté précité $\overline{CPrech}$ et délivrant le signal de commande de précharge CPrech proprement dit. De manière classique, on indique que l'inverseur 2 peut être constitué par un transistor PMOS $TP_5$ et un transistor NMOS $TN_5$ connectés en série entre la tension d'alimentation Vdd et la tension de référence Vss. L'électrode de grille commune des transistors précités reçoit le signal de commande de précharge complémenté et le point commun drain-source des transistors $TP_5$ et $TN_5$ délivre le signal de commande de précharge proprement dit CPrech.

Le mode opératoire de l'amplificateur de ligne, objet de la présente invention, tel que représenté en figure 2a, sera décrit en liaison avec la figure 2b, laquelle représente les principaux signaux mis en oeuvre, signal de commande $RS_1$, signal de commande de précharge complémenté $\overline{CPrech}$, signal de commande en lecture CL, et, enfin, signal de sortie S et son complément $\overline{S}$, ce signal de sortie S étant synchrone du signal de lecture bit SL mais correspondant de manière plus spécifique au signal de sortie délivré en un noeud interne $IN_4$ constitué par la première liaison directe précédemment mentionnée dans la description.

En ce qui concerne le mode opératoire de l'amplificateur de ligne tel que représenté en figure 2a, on indique, d'une manière générale, que la réaction positive est réalisée par la première et la deuxième liaison directe entre les transistors PMOS $TP_1$, NMOS $TN_1$ de la première branche $1_1$ et les transistors PMOS $TP_2$ et NMOS $TN_3$ de la deuxième branche $1_2$.

Les transistors de multiplexage $T_{mux1}$ à $T_{mux4}$ constituent en fait un multiplexeur analogique de deux voies parmi quatre permettant d'appliquer le signal bit et le signal bit complémenté D, $\overline{D}$ sur les noeuds internes $IN_1$ et $IN_2$, soit finalement sur l'électrode de grille du transistor PMOS $TP_1$ de la première branche et du transistor PMOS $TP_2$ de la deuxième branche. Le transistor de commutation $TP_3$ entre la première et la deuxième liaison directe, c'est-à-dire entre le troisième $IN_3$ et le quatrième $IN_4$ noeud interne, permet, sur commutation, d'égaliser la valeur de la tension appliquée aux noeuds internes $IN_1$, $IN_2$ et $IN_3$, $IN_4$ précités, c'est-à-dire en fait sur la bascule de type bistable réalisée par la première branche $1_1$ et la deuxième branche $1_2$ munies des liaisons directes précitées constituant la réaction positive. Le transistor NMOS $TN_2$ est utilisé pendant une phase dite d'évaluation, pendant laquelle le transistor NMOS $TN_2$ commun à la première et à la deuxième branche $1_1$ et $1_2$ permet d'amplifier la différence préliminaire entre les niveaux de tension engendrés par une transition du signal bit D et du signal bit complémenté $\overline{D}$, cette phase d'évaluation étant bien entendu commandée par le passage au niveau haut du signal de commande de lecture CL ainsi que représenté en figure 2b, alors que le transistor NMOS $TN_4$, transistor de précharge, est utilisé pendant une phase de précharge, laquelle est commandée par le passage au niveau bas du signal de commande de précharge complémenté $\overline{CPrech}$, respectivement par le signal de commande de précharge proprement dit CPrech. On comprend ainsi que, en référence à la figure 2b, le signal bit $D_1$ et le signal bit complémenté $\overline{D}_1$ par exemple étant appliqués aux noeuds internes $IN_1$ et $IN_2$ respectivement pour constituer le signal bit D respectivement bit complémenté $\overline{D}$, le passage au niveau bas du signal de précharge complémenté $\overline{CPrech}$ permet d'effectuer une précharge de la première et de la deuxième branche $1_1$ et $1_2$, puis la précharge étant ainsi réalisée, le passage au niveau haut du signal de commande de lecture CL et du signal de précharge complémenté $\overline{CPrech}$ permet alors d'effectuer en fait la lecture proprement dite ou évaluation pour délivrer ensuite le signal de sortie S représentatif de la valeur du signal bit D.

On indique que tous les autres transistors utilisés et représentés sur la figure 2a sont des éléments constitutifs supplémentaires permettant d'assurer, soit une meilleure mise en forme du signal délivré par l'amplificateur de ligne objet de la présente invention, soit de permettre une séparation efficace de l'amplificateur de ligne, objet de la présente invention, tel que représenté en figure 2a, des circuits externes.

On indique que les signaux représentés en figure 2b correspondent au cas non-limitatif où le signal analogique du signal bit D est supérieur au signal analogique du signal bit complémenté $\overline{D}$.

D'une manière générale, on rappelle que lorsque les signaux de commande de multiplexage $RS_0$ et $RS_1$ sont au niveau logique haut et que le signal de commande de précharge complémenté $\overline{CPrech}$ est au niveau logique bas alors que le signal de commande de lecture CL est au niveau logique bas, l'amplificateur de ligne, objet de la présente invention, tel que représenté en figure 2a, est dans un état stable car il se trouve alors complètement déconnecté des signaux bit et bit complémenté $D_0$,$D_1$ et $\overline{D}_0$,$\overline{D}_1$. Dans une telle situation, les transistors de précharge $TN_4$ et de commutation $TP_3$ permettant l'égalisation des tensions entre les noeuds internes $IN_1$, $In_2$ et $IN_3$, $IN_4$ maintiennent les noeuds internes de l'amplificateur de ligne précité à une valeur de tension $V_0$, laquelle vérifie la relation :

$$V_0 = Vdd - Ven - Vben + Veq.$$

Dans la relation précitée, on indique que Vdd désigne bien entendu la tension d'alimentation, Ven est la tension de seuil du transistor de type canal N pour une tension de source-substrat nulle, Vben est la tension d'effet de substrat associée au même transistor, Veq désignant les tensions introduites par le premier transistor PMOS $TP_1$ de la première branche et par le deuxième transistor PMOS $TP_2$ de la deuxième branche en raison du fait que ces transistors sont à l'état conducteur et introduisent ainsi une chute de tension correspondante. Simultanément, les lignes de bits globales, c'est-à-dire celles transmettant les valeurs des signaux bit $D_0$,$D_1$ et signaux bit complémentés $\overline{D}_0$,$\overline{D}_1$ sont également préchargées à une valeur de tension $V_0$ + Veq, des dispositifs à transistors MOS de canal N pouvant être utilisés pour réduire l'amplitude de commutation sur les lignes de bits précitées.

Lorsqu'au contraire, une opération de lecture est réalisée, l'un des signaux de lecture $RS_0$ ou $RS_1$ par exemple, ainsi que représenté en figure 2b, est amené au niveau logique bas. En conséquence, les lignes de données correspondantes commencent à se décharger en raison du fait que les transistors d'accès aux cellules de mémoire correspondantes sont conducteurs ; les transistors de multiplexage ont été mis en position de conduction par le signal $RS_1$ ou $RS_0$. Le signal de commande de précharge complémenté $\overline{CPrech}$ est alors amené à son niveau haut, ainsi que représenté en figure 2b, et la bascule bistable constituée par la première et la deuxième branche $1_1$ et $1_2$ et par les liaisons directes précédemment mentionnées, et donc par les transistors PMOS $TP_1$ et NMOS $TN_1$ de la première branche respectivement transistors PMOS $TP_2$ et NMOS $TN_3$ de la deuxième branche, perd son état d'équilibre, les potentiels sur les noeuds internes $IN_1$ et $IN_2$ étant alors déséquilibrés. Lorsque la différence de tension entre les noeuds internes précités atteint quelques dizaines de millivolts, de l'ordre de 50 millivolts, le signal de commande de lecture CL atteint le niveau logique haut et permet de maintenir la bascule bistable précitée dans son état stable correspondant. Le premier transistor NMOS $TN_1$ de la première branche ou le troisième transistor NMOS $TN_3$ de la deuxième branche, ainsi que le deuxième transistor NMOS $TN_2$ commun à la première et à la deuxième branche, déchargent alors le noeud interne $IN_3$ ou $IN_4$ dont le potentiel est le plus bas. Le courant de décharge circule alors à travers les diodes $Td_1$ et $Td_2$ en sens opposé, ce qui a pour effet de limiter la valeur basse de la tension appliquée sur $IN_1$ ou $IN_2$ du fait de la décharge aux noeuds internes au potentiel le plus bas à la valeur $|Vtp+Vbep|$, valeur dans laquelle Vtp représente la valeur de seuil de tension du transistor MOS de type canal P pour une tension de source-substrat nulle et où Vbep représente la tension d'effet de substrat associée au même transistor.

De manière plus particulière, on indique que chaque diode permettant de limiter la valeur basse de la tension appliquée sur l'électrode de grille du premier $TP_1$ et du deuxième $TP_2$ transistor PMOS, et donc sur les noeuds internes correspondants $IN_1$ et $IN_2$, est formée avantageusement par un transistor PMOS $Td_1$, $Td_2$ dont l'électrode de grille est connectée à la tension de référence Vss.

Ce mode de réalisation permet d'obtenir pour la valeur positive déterminée une valeur de tension voisine de trois volts pour le temps de décharge considéré. Les transistors $Td_1$ et $Td_2$ utilisés pour réaliser les diodes précédemment cités peuvent avantageusement être dimensionnés de façon à présenter une résistance relativement importante de façon à éviter la propagation d'un niveau de tension bas sur les lignes de bits, lesquelles bien entendu ont été mises en communication avec le noeud interne correspondant $IN_1$ respectivement $IN_2$ du fait de la commutation et de la liaison des noeuds internes précités aux lignes de bits globales correspondantes par les transistors de multiplexage qui ont été sélectionnés. Dans l'exemple précédemment décrit, on comprend ainsi que le niveau de tension maintenu sur la ligne de bits correspondante au niveau bas est alors égal à 3 volts.

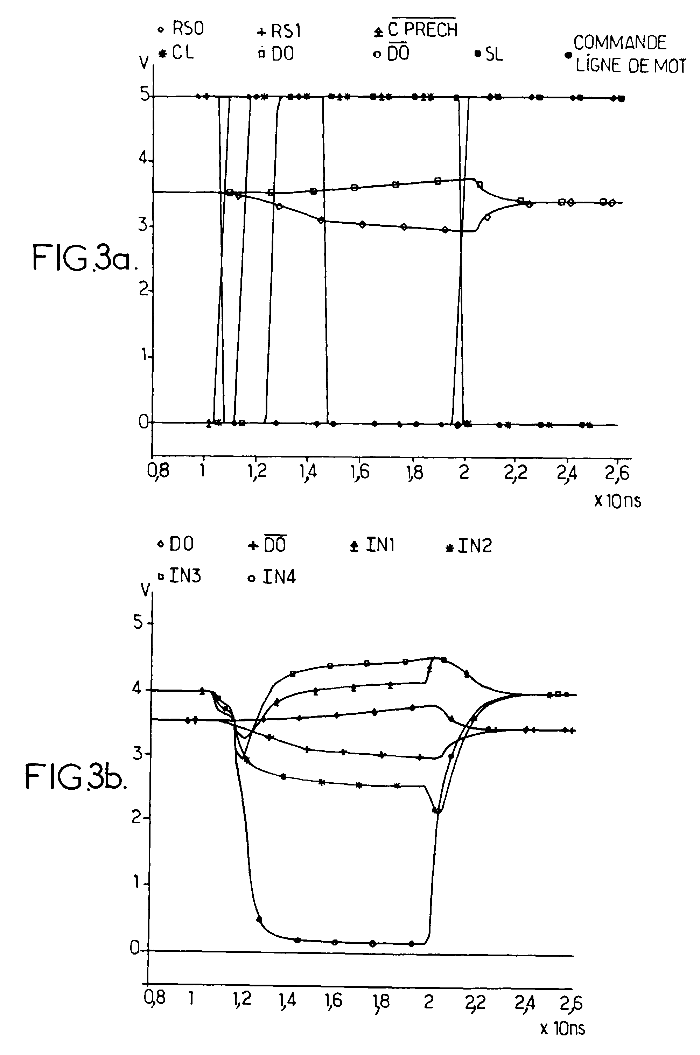

Une description plus détaillée de l'évolution des tensions remarquables en des points de test particuliers de l'amplificateur de ligne, objet de la présente invention représenté en figure 2a, sera maintenant décrite en liaison avec les figures 3a et 3b.

Sur les figures précitées, l'axe des ordonnées est gradué en valeur de tension en volts et l'axe des abscisses est gradué en dizaines de nano-secondes.

Les chronogrammes précités ont été obtenus à partir d'un mode de réalisation dans lequel 512 cellules mémoires étaient connectées aux lignes de bits globales délivrant les signaux bits $D_1$, $D_0$ respectivement signaux bits complémentés $\overline{D}_0$, $\overline{D}_1$.

Sur la figure 3a, on a représenté les chronogrammes des signaux relatifs au signal de commande de multiplexage $RS_0$, $RS_1$, au signal de commande de lecture CL, au signal correspondant au signal bit D et bit complémenté $\overline{D}$ au niveau des noeuds internes $IN_1$ et $IN_2$ respectivement, au signal de commande de préchargé complémenté $\overline{CPrech}$, et, enfin, au signal de lecture SL délivré par l'étage de sortie 4.

Sur la figure 3b, on a représenté le signal global bit $D_0$ et le signal global bit complémenté $\overline{D}_0$, les signaux correspondant au premier noeud et au deuxième noeud interne $IN_1$ et $IN_2$, les signaux correspondant au troisième et au quatrième noeud interne $IN_3$ et $IN_4$.

On peut constater sur la figure 3b l'existence d'un décrochement des tensions au troisième et au quatrième noeud interne $IN_3$, $IN_4$ durant la phase d'évaluation, ce décrochement étant provoqué par le deuxième transistor NMOS $TN_2$, lequel amplifie la différence préliminaire entre les niveaux de tension du signal bit et du signal bit complémenté D, $\overline{D}$ au premier $IN_1$ respectivement au deuxième $IN_2$ noeud interne.

Ainsi qu'on l'a représenté en outre en figure 2a, on indique que l'amplificateur de ligne, objet de la présente invention, peut comprendre en outre, connecté directement à la première, respectivement à la deuxième liaison directe, c'est-à-dire en définitive au troisième respectivement au quatrième noeud interne $IN_3$, $IN_4$, un étage de sortie intermédiaire formé par un transistor PMOS et un transistor NMOS connectés en série entre la tension d'alimentation Vdd et la tension de référence Vss. Les transistors correspondants portent la référence $TP_{63}$ et $TN_{63}$ pour ce qui concerne l'étage de sortie intermédiaire connecté au noeud interne $IN_3$ et la référence $TP_{64}$ respectivement $TN_{64}$ pour ce qui concerne l'étage de sortie intermédiaire connecté au quatrième noeud interne $IN_4$. L'électrode de grille commune des transistors $TP_{63}$, $TN_{63}$ respectivement $TP_{64}$, $TN_{64}$ est connectée à la première respectivement à la deuxième liaison directe, c'est-à-dire en fait aux troisième et quatrième noeuds internes $IN_3$ et $IN_4$ respectivement. On indique que le point commun drain-source des transistors $TP_{63}$ et $TN_{63}$ respectivement $TP_{64}$ et $TN_{64}$ délivre le signal de lecture bit respectivement le signal de lecture bit complémenté ou, de manière plus spécifique, le signal S tel que représenté en figure 2a.

Selon un mode de réalisation plus avantageux, on indique que les étages de sortie intermédiaire précédemment cités peuvent comprendre en outre, intercalé entre le transistor PMOS et le transistor NMOS $TP_{63}$, $TN_{63}$ respectivement $TP_{64}$, $TN_{64}$, un transistor PMOS $TP_{73}$, $TP_{74}$ dont l'électrode de grille est commandée par le signal de commande de précharge CPrech délivré par l'inverseur 2. Les transistors PMOS $TP_{73}$ et $TP_{74}$ permettent d'annuler le courant dans les branches de sortie puisque les transistors NMOS $TN_{63}$ et $TN_{64}$ sont conducteurs pendant la phase de précharge.

Enfin, l'étage de sortie intermédiaire tel que l'étage de sortie intermédiaire relatif au quatrième noeud intermédiaire $IN_4$ peut être avantageusement suivi d'une bascule à verrouillage, portant la référence 3, à laquelle peut être connecté l'étage de sortie proprement dit 4, lequel joue alors le rôle d'étage séparateur et de mémoire.

De manière classique, la bascule de verrouillage peut comprendre un transistor en commutation de type NMOS, noté $T_{11}$, connecté entre la sortie de l'étage de sortie intermédiaire formé par les transistors $TP_{64}$, $TN_{64}$ et $TP_{74}$ et une bascule de verrouillage proprement dite formée de manière classique par des transistors $Tl_2$, $Tl_3$, $Tl_4$, $Tl_5$, ces transistors de type PMOS, NMOS respectivement, constituant en fait les deux étages d'une bascule, les transistors $Tl_4$ et $Tl_5$ permettant de maintenir le niveau mémorisé lorsque le transistor NMOS $Tl_1$ est bloqué pendant la phase de précharge.

De la même façon, l'étage de sortie formant étage séparateur 4 peut être formé par deux transistors PMOS $TS_1$ et NMOS $TS_2$ connectés entre la tension d'alimentation Vdd et la tension de référence Vss, cet étage de sortie séparateur recevant le signal délivré par la bascule de verrouillage 3 et délivrant le signal bit de lecture SL.

On a ainsi décrit un amplificateur de ligne pour mémoire statique RAM particulièrement performant dans la mesure où l'ensemble des caractéristiques techniques précédemment mentionnées dans la description permet d'obtenir l'ensemble des buts recherchés. En outre, on indique que, en raison de l'architecture globale retenue pour la mise en oeuvre d'un tel amplificateur de ligne, l'implantation sous forme de circuit intégré apparaît particulièrement simple alors que la mise en oeuvre des signaux de commande peut facilement être réalisée.

Enfin, on indique que l'amplificateur de ligne pour mémoire statique RAM, objet de la présente invention, apparaît particulièrement intéressant dans la mesure où celui-ci est muni d'entrées multiplexées pour les signaux bit et bit complémenté, cette fonctionnalité apparaissant d'un intérêt majeur en raison du fait qu'il n'est pas possible d'augmenter dans les mémoires actuelles le nombre de lignes de mots à l'infini, alors que ces mémoires présentent un caractère de densité de plus en plus important, le multiplexage permettant ainsi de diviser le nombre de lignes de mots par une constante, le plus souvent une puissance de deux, alors que la largeur du champ de données de mots est multipliée par la même constante. Compte tenu du fait que le nombre des ports de sortie externe de la mémoire ne peuvent varier, les entrées sont ainsi multiplexées. En outre, on indique que les transistors de multiplexage n'interviennent pas dans le fonctionnement proprement dit de l'amplificateur, objet de l'invention, dans lequel, grâce à la présence des transistors $Td_1$ et $Td_2$, il est possible de maintenir pendant le temps de décharge une valeur de tension appropriée sur les lignes véhiculant le signal bit, et de ce fait d'obtenir une vitesse de commutation rapide.

## Revendications

**1.** Amplificateur de ligne pour mémoire statique RAM, comprenant un étage différentiel à réaction positive entre une première et une deuxième branche connectées entre une tension d'alimentation (Vdd) et une tension de référence (Vss), chaque branche recevant au moins un signal bit (D) respectivement le signal bit complémenté ($\bar{D}$), et un étage de sortie délivrant un signal de lecture bit (S), caractérisé en ce que ladite première branche comporte au moins :

- un premier transistor PMOS ($TP_1$), un premier transistor NMOS ($TN_1$) et un deuxième transistor NMOS ($TN_2$) connectés en série entre la tension d'alimentation et la tension de référence, l'électrode de grille du premier transistor PMOS ($TP_1$) recevant le signal bit (D), étant reliée à l'électrode de grille du premier transistor NMOS ($TN_1$) par l'intermédiaire d'une diode ($Td_1$), permettant de limiter la valeur basse de la tension appliquée sur l'électrode de grille du premier transistor PMOS ($TP_1$) à une valeur positive déterminée, l'électrode de grille dudit deuxième transistor NMOS ($TN_2$) recevant un signal de commande en lecture (CL),

et en ce que ladite deuxième branche comporte au moins :

- un deuxième transistor PMOS ($TP_2$) et un troisième transistor NMOS ($TN_3$) connectés en série entre la tension d'alimentation (Vdd) et le point commun drain-source du premier et du deuxième transistor NMOS ($TN_1$, $TN_2$) de la première branche, l'électrode de grille du deuxième transistor PMOS ($TP_2$) recevant le signal bit complémenté ($\bar{D}$) étant reliée à l'électrode de grille du troisième transistor NMOS ($TN_3$) par l'intermédiaire d'une diode ($Td_2$) per-

mettant de limiter la valeur basse de la tension appliquée sur l'électrode de grille du deuxième transistor PMOS (TP$_2$) à ladite valeur de seuil positive déterminée, ledit deuxième transistor NMOS (TN$_2$) commun à la première et à la deuxième branche permettant d'amplifier la différence préliminaire entre les niveaux de tension engendrés par une transition du signal bit (D) et du signal bit complémenté ($\bar{D}$),

lesdites première et deuxième branches comportant en outre :

- un transistor NMOS de précharge (TN$_4$) connecté entre la tension d'alimentation et le point commun drain-source entre le premier, le deuxième et le troisième transistor NMOS de la première et de la deuxième branche, l'électrode de grille du transistor de précharge recevant un signal de commande de précharge (CPrech), et formant ladite réaction positive,
- une première liaison directe entre le point commun drain-source du premier transistor PMOS (TP$_1$) et du premier transistor NMOS (TN$_1$) de la première branche et l'électrode de grille du troisième transistor NMOS (TN$_3$) de la deuxième branche,
- une deuxième liaison directe entre le point commun drain-source du deuxième transistor PMOS (TP$_2$) et du troisième transistor NMOS (TN$_3$) de la deuxième branche et l'électrode de grille du premier transistor NMOS (TN$_1$) de la première branche,
- un transistor de commutation de type PMOS (TP$_3$) reliant la première et la deuxième liaison directe et dont l'électrode de grille est commandée par le signal de commande de préchargé complémenté.

2. Amplificateur selon la revendication 1, caractérisé en ce que chaque diode permettant de limiter la valeur basse de la tension appliquée sur l'électrode de grille du premier (TP$_1$) respectivement du deuxième (TP$_2$) transistor PMOS est formée par un transistor PMOS (Td$_1$, Td$_2$) dont l'électrode de grille est connectée à la tension de référence (Vss), ce qui permet d'obtenir pour ladite valeur positive déterminée une valeur de tension voisine de 3 volts.

3. Amplificateur selon l'une des revendications 1 ou 2, caractérisé en ce que celui-ci comprend en outre un inverseur formé par un transistor PMOS (TP$_5$) et un transistor NMOS (TN$_5$) connectés en série entre la tension d'alimentation (Vdd) et la tension de référence (Vss), l'électrode de grille commune desdits transistors recevant ledit signal de commande de précharge complémenté et le point commun drain-source desdits transistors délivrant ledit signal de commande de précharge.

4. Amplificateur selon l'une des revendications 1 à 3, caractérisé en ce que celui-ci comprend en outre, connecté directement à la première respectivement deuxième liaison directe, un étage de sortie intermédiaire formé par un transistor PMOS (TP$_{64}$) et un transistor NMOS (TN$_{64}$) connectés en série entre la tension d'alimentation (Vdd) et la tension de référence (Vss), l'électrode de grille commune desdits transistors étant connectée à ladite première respectivement deuxième liaison directe, le point commun drain-source desdits transistors délivrant le signal de lecture bit (S).

5. Amplificateur selon la revendication 4, caractérisé en ce que l'un au moins des étages de sortie comprend en outre, intercalé entre ledit transistor PMOS et ledit transistor NMOS, un transistor PMOS (TP$_{73}$,TP$_{74}$) dont l'électrode de grille est commandée par ledit signal de commande de précharge.

6. Amplificateur selon la revendication 4 ou 5, caractérisé en ce que l'étage de sortie intermédiaire est suivi d'une bascule à verrouillage et d'un étage séparateur.

**Patentansprüche**

1. Leitungsverstärker für statische RAM-Speicher mit einer Differenzstufe mit positiver Rückkopplung zwischen einem ersten und einem zweiten Zweig, die zwischen einer Speisespannung (Vdd) und einer Referenzspannung (Vss) angeordnet sind, wobei jeder Zweig wenigstens ein Signalbit (D) bzw. das komplementäre Signalbit ($\bar{D}$) empfängt, sowie mit einer Ausgangsstufe, die ein Lesesignalbit (S) ausgibt,
   **dadurch gekennzeichnet**,
   daß der erste Zweig wenigstens aufweist:

   - einen ersten PMOS-Transistor (TP$_1$), einen ersten NMOS-Transistor (TN$_1$) und einen zweiten NMOS-Transistor (TN$_2$), die in Reihe zwischen der Speisespannung und der Referenzspannung angeordnet sind, wobei die Gate-Elektrode des ersten PMOS-Transistors (TP$_1$), der das Signalbit (D) aufnimmt, über eine Diode (Td$_1$), die den unteren Wert der an der Gate-Elektrode des ersten PMOS-Transistor (TP$_1$) anliegenden Spannung auf einen vorbestimmten positiven Wert begrenzt, mit der Gate-Elektrode des ersten NMOS-Transistor (TN$_1$) verbunden ist und wobei der Gate-Elektrode des zweiten NMOS-Transistors (TN$_2$) ein Lese-Steuersignal zugeführt wird,

und daß der zweite Zweig wenigstens aufweist:

- einen zweiten PMOS-Transistor (TP$_2$) und einen dritten NMOS-Transistor (TN$_3$), die in Reihe zwischen der Speisespannung (Vdd) und dem Drain-Source-Verbindungspunkt des ersten und zweiten NMOS-Transistors (TN$_1$, TN$_2$) des ersten Zweiges angeordnet sind, wobei die Gate-Elektrode des zweiten PMOS-Transistors (TP$_2$), der das komplementäre Signalbit ($\bar{D}$) zugeführt wird, über eine Diode (Td$_2$), die den unteren Wert der an der Gate-Elektrode des zweiten PMOS-Transistor (TP$_2$) anliegenden Spannung auf den genannten vorbestimmten positiven Schwellwert begrenzt, mit der Gate-Elektrode des dritten NMOS-Transistor (TN$_3$) verbunden ist und wobei der zweite NMOS-Transistor (TN$_2$), der dem ersten und dem zweiten Zweig gemeinsam ist, das Verstärken der transitorischen Differenz zwischen den durch einen Übergang des Signalbits (D) und des komplementaren Signalbits ($\bar{D}$) verursachten Spannungspegeln ermöglicht,

wobei der erste und der zweite Zweig ferner aufweisen:

- einen NMOS-Vorlade-Transistor (TN$_4$), der zwischen der Speisespannung und dem Drain-Source-Verbindungspunkt des ersten, zweiten und dritten NMOS-Transistors des ersten und des zweiten Zweiges angeordnet ist, wobei dieser erste Vorlade-Transistor an seiner Gate-Elektrode ein Vorlade-Steuersignal (CPrech) aufnimmt und die genannte positive Rückkopplung bildet,
- eine erste Direktverbindung zwischen dem Drain-Source-Verbindungspunkt des ersten PMOS-Transistors (TP$_1$) und des ersten NMOS-Transistors (TN$_1$) des ersten Zweiges und der Gate-Elektrode des dritten NMOS-Transistors (TN$_3$) des zweiten Zweiges,
- eine zweite Direktverbindung zwischen dem Drain-Source-Verbindungspunkt des zweiten PMOS-Transistors (TP$_2$) und des dritten NMOS-Transistors (TN$_3$) des zweiten Zweiges und der Gate-Elektrode des ersten NMOS-Transistors (TN$_1$) des ersten Zweiges,
- einen Umschalt-Transistor (TP$_3$) vom PMOS-Typ, der die erste und die zweite Direktverbindung miteinander verbindet und dessen Gate-Elektrode durch das komplementäre Vorlade-Steuersignal gesteuert wird.

2. Verstärker nach Anspruch 1, dadurch gekennzeichnet, daß jede Diode, die die Begrenzung des unteren Wert der an der Gate-Elektrode des ersten PMOS-Transistors (TP$_1$) bzw. des zweiten PMOS-Transistors (TP$_2$) anliegenden Spannung ermöglicht, aus einem PMOS-Transistor (Td$_1$, Td$_2$) besteht, dessen Gate-Elektrode mit der Referenzspannung (Vss) verbunden ist und der es ermöglicht, daß der genannte positive Wert einen Spannungswert von etwa 3 Volt hat.

3. Verstärker nach einem der Ansprüche 1 oder 2, dadurch gekennzeichnet, daß er ferner einen Inverter aufweist, der aus einem PMOS-Transistor (TP$_5$) und einem NMOS-Transistor (TN$_5$) besteht, die in Reihe zwischen der Speisespannung (Vdd) und der Referenzspannung (Vss) angeordnet sind, wobei der gemeinsamen Gate-Elektrode dieser Transistoren das komplementäre Vorlade-Steuersignal zugeführt wird und der Drain-Source-Verbindungspunkt der Transistoren das Vorlade-Steuersignal liefert.

4. Verstärker nach einem der Ansprüche 1 bis 3, dadurch gekennzeichnet, daß er weiterhin eine direkt mit der ersten bzw. der zweiten Direktverbindung verbundene Zwischen-Ausgangsstufe aufweist, die von einem PMOS-Transistor (TP$_{64}$) und einem NMOS-Transistor (TN$_{64}$) gebildet wird, die in Reihe zwischen der Speisespannung (Vdd) und der Referenzspannung (Vss) angeordnet sind, wobei die gemeinsamen Gate-Elektrode dieser Transistoren mit der ersten bzw. der zweiten Direktverbindung verbunden ist und der Drain-Source-Verbindungspunkt der Transistoren das Lesesignalbit (S) liefert.

5. Verstärker nach Anspruch 4, dadurch gekennzeichnet, daß wenigstens eine der Ausgangsstufen außerdem einen zwischen dem genannten PMOS-Transistor und dem NMOS-Transistor eingefügten PMOS-Transistor (TP$_{73}$, TP$_{74}$) aufweist, dessen Gate-Elektrode von dem Vorlade-Steuersignal gesteuert wird.

6. Verstärker nach einem der Ansprüche 4 oder 5, dadurch gekennzeichnet, daß auf die Zwischen-Ausgangsstufe ein selbsthaltende Kippstufe und eine Trennstufe folgen.

**Claims**

1. Line amplifier for a static RAM memory, comprising a differential stage with positive feedback between a first and a second branch which are connected between a power supply voltage (Vdd) and a reference voltage (Vss), each branch receiving at least one bit signal (D) and the complemented bit signal ($\bar{D}$) respectively, and an output stage delivering a bit read signal (S), characterized in that the said first branch includes at least:

- a first PMOS transistor ($TP_1$), a first NMOS transistor ($TN_1$) and a second NMOS transistor ($TN_2$) which are connected in series between the power supply voltage and the reference voltage, the gate electrode of the first PMOS transistor ($TP_1$) receiving the bit signal (D) being linked to the gate electrode of the first NMOS transistor ($TN_1$) via a diode ($Td_1$), making it possible to limit the low value of the voltage applied to the gate electrode of the first PMOS transistor ($TP_1$) to a defined positive value, the gate electrode of the said second NMOS transistor ($TN_2$) receiving a read control signal (CL),

and in that the said second branch includes at least:

- a second PMOS transistor ($TP_2$) and a third NMOS transistor ($TN_3$) which are connected in series between the power supply voltage (Vdd) and the drain-source common point of the first and of the second NMOS transistor ($TN_1$, $TN_2$) of the first branch, the gate electrode of the second PMOS transistor ($TP_2$) receiving the complemented bit signal ($\bar{D}$) being linked to the gate electrode of the third NMOS transistor ($TN_3$) via a diode ($Td_2$) making it possible to limit the low value of the voltage applied to the gate electrode of the second PMOS transistor ($TP_2$) to the said defined positive threshold value, the said second NMOS transistor ($TN_2$) common to the first and to the second branch making it possible to amplify the preliminary difference between the voltage levels generated by a transition of the bit signal (D) and of the complemented bit signal ($\bar{D}$),

the said first and second branches further including:

- a precharge NMOS transistor ($TN_4$) connected between the power supply voltage and the drain-source common point between the first, the second and the third NMOS transistor of the first and of the second branch, the gate electrode of the precharge transistor receiving a precharge control signal (CPrech), and forming the said positive feedback,
- a first direct link between the drain-source common point of the first PMOS transistor ($TP_1$) and of the first NMOS transistor ($TN_1$) of the first branch and the gate electrode of the third NMOS transistor ($TN_3$) of the second branch,
- a second direct link between the drain-source common point of the second PMOS transistor ($TP_2$) and of the third NMOS transistor ($TN_3$) of the second branch and the gate electrode of the

first NMOS transistor ($TN_1$) of the first branch,
- a PMOS-type switching transistor ($TP_3$) linking the first and the second direct link, and the gate electrode of which is driven by the complemented precharge control signal.

2. Amplifier according to Claim 1, characterized in that each diode making it possible to limit the low value of the voltage applied to the gate electrode of the first ($TP_1$) and of the second ($TP_2$) PMOS transistor respectively is formed by a PMOS transistor ($Td_1$, $Td_2$) the gate electrode of which is connected to the reference voltage (Vss), which makes it possible, for the said defined positive value, to obtain a voltage value close to 3 volts.

3. Amplifier according to either of Claims 1 and 2, characterized in that it further comprises an invertor formed by a PMOS transistor ($TP_5$) and an NMOS transistor ($TN_5$) which are connected in series between the power supply voltage (Vdd) and the reference voltage (Vss), the common gate electrode of the said transistors receiving the said complemented precharge control signal and the drain-source common point of the said transistors delivering the said precharge control signal.

4. Amplifier according to one of Claims 1 to 3, characterized in that it further comprises, connected directly to the first and to the second direct link respectively, an intermediate output stage formed by a PMOS transistor ($TP_{64}$) and an NMOS transistor ($TN_{64}$) which are connected in series between the power supply voltage (Vdd) and the reference voltage (Vss), the common gate electrode of the said transistors being connected to the said first and second direct link respectively, the drain-source common point of the said transistors delivering the bit read signal (S).

5. Amplifier according to Claim 4, characterized in that at least one of the output stages further comprises, interposed between the said PMOS transistor and the said NMOS transistor, a PMOS transistor ($TP_{73}$, $TP_{74}$) the gate electrode of which is driven by the said precharge command signal.

6. Amplifier according to Claim 4 or 5, characterized in that the intermediate output stage is followed by a two-state latch and by a separator stage.

EP 0 750 311 B1

RÉSEAU DE
MÉMOIRES

DÉCODEUR

CELLULE MÉMOIRE

LIGNE DE MOT

LIGNES DE BIT

LIGNES DÉCODEUR

CIRCUIT DE
PILOTAGE DE
LIGNES

UNITÉ
DE
COMMANDE

AMPLIFICATEUR
DE LIGNE

LIGNES DE COMMANDE
D'AMPLIFICATEUR DE
LIGNE

FIG.1a.
(ART ANTÉRIEUR)

Vpol

Vdd    Vdd

Ō      D      S

Vss    Vss    Vss

FIG.1b.
(ART ANTÉRIEUR)

Vdd  1̄1   Vdd  1̄2   Vdd

Ō         D         S

Vss    Vss    Vss

FIG.1c.
(ART ANTÉRIEUR)

11

FIG.2a.

FIG.2b.

EP 0 750 311 B1

FIG.3a.

FIG.3b.